# EUROPEAN PATENT APPLICATION

(11) **EP 4 838 870 A1**
(43) Date of publication of application: **11.11.2026**
(21) Application number: 26167490.7
(22) Date of filing: 25.03.2026
(51) Int. Cl.: H04M 1/02, G06F 1/16, G02F 1/1333, G02F 1/1335

(54) **DISPLAY DEVICE AND ELECTRONIC DEVICE INCLUDING THE SAME**

(30) Priority: 09.05.2025 KR 20250060680
(71) Applicant: Samsung Display Co., Ltd., Yongin-si, Gyeonggi-do 17113 (KR)
(72) Inventor: Kim, Jeongjin, 17113 Yongin-si, Gyeonggi-do (KR); Ro, Jinyoung, 17113 Yongin-si, Gyeonggi-do (KR); Park, Hyungjun, 17113 Yongin-si, Gyeonggi-do (KR); Baek, Seunghwan, 17113 Yongin-si, Gyeonggi-do (KR); Sung, Siwoong, 17113 Yongin-si, Gyeonggi-do (KR)
(74) Representative: Gulde & Partner

(57) **Abstract**

A display device includes: a display panel (10) including a first surface to display an image, and a second surface opposite to the first surface; a polarizing layer (500) on the first surface of the display panel (10), at least a portion of the polarizing layer (500) protruding outward from the display panel (10) more than at least a portion of an edge of the display panel (10); and a shock absorbing layer (LM) corresponding to at least a portion of a side of the polarizing layer (500), and to shield the at least the portion of the side of the polarizing layer (500) and an upper surface of the polarizing layer (500) at an edge portion of the polarizing layer (500). **In** an alternative embodiment, the polarizing layer (500) includes a first area overlapping with a display area of the display panel (10); and a second area extending from the first area, wherein at least a portion of the second area protrudes outward from the display panel (10) more than at least a portion of an edge of the display panel (10), and wherein a light transmittance of the second area is different from a light transmittance of the first area.

## Description

### BACKGROUND

### 1. Field

Aspects of embodiments of the present disclosure relate to a display device and an electronic device.

### 2. Description of the Related Art

Electronic devices based on mobility are being widely used. Recently, tablet personal computers (PCs) are being widely used for mobile electronic devices other than small electronic devices, such as mobile phones.

To support various functions, mobile electronic devices include display devices to provide visual information, such as images or moving images. Recently, as other components to drive the display devices are being miniaturized, the importance of display devices in the electronic devices has increased, and structures in which certain angles are formed in a planarized state are being developed.

The above information disclosed in this Background section is for enhancement of understanding of the background of the present disclosure, and therefore, it may contain information that does not constitute prior art.

### SUMMARY

In general, when an impact is applied to the side of a display device, a dark spot may occur in a display panel due to a separation between an inorganic insulating layer and an organic insulating layer of the display panel, or at least one of a plurality of wires disposed on a substrate of the display panel may be disconnected. In such cases, dark spots may be visible from the outside of the display device, or the display device may malfunction, regardless of whether the display device is operating or not.

Embodiments of the present disclosure may be directed to a display device and an electronic device, in which a polarizing film protrudes more than a display panel, and a shock absorbing member is disposed on a side of the polarizing film and the display panel.

However, the present disclosure is not limited to the above aspects and features, and the above and additional aspects will be set forth, in part, in the description that follows, and in part, will be apparent from the description, or may be learned by practicing one or more of the presented embodiments of the present disclosure.

According to one or more embodiments of the present disclosure, a display device includes: a display panel including a first surface configured to display an image, and a second surface opposite to the first surface; a polarizing layer on the first surface of the display panel, at least a portion of the polarizing layer protruding outward from the display panel more than at least a portion of an edge of the display panel; and a shock absorbing layer corresponding to at least a portion of a side of the polarizing layer, and configured to shield the at least the portion of the side of the polarizing layer and an upper surface of the polarizing layer at an edge portion of the polarizing layer.

In an embodiment, the display device may further include a housing in which the shock absorbing layer may be accommodated.

In an embodiment, the display device may further include a cover member on the polarizing layer.

In an embodiment, an end of the cover member may protrude outward from the polarizing layer more than an end of the polarizing layer.

In an embodiment, the display device may further include a panel protecting member on the second surface of the display panel.

In an embodiment, the display device may further include a shielding member on a surface of the panel protecting member.

In an embodiment, the display device may further include a protective cover on at least one of the polarizing layer or the panel protecting member.

In an embodiment, at least a portion of a planar shape of the display panel may be rounded.

In an embodiment, an end of the polarizing layer may protrude outward from an end of the display panel by 50 µm or more.

According to one or more embodiments of the present disclosure, a display device includes: a display panel including a first surface configured to display an image, and a second surface opposite to the first surface; and a polarizing layer on the first surface, the polarizing layer including: a first area overlapping with a display area of the display panel; and a second area extending from the first area. At least a portion of the second area protrudes outward from the display panel more than at least a portion of an edge of the display panel, and a light transmittance of the second area is different from a light transmittance of the first area.

In an embodiment, the light transmittance of the first area may be greater than the light transmittance of the second area.

In an embodiment, the display device may further include a cover member on the polarizing layer.

In an embodiment, the display device may further include a panel protecting member on the second surface of the display panel.

In an embodiment, the display device may further include a shielding member on a surface of the panel protecting member.

In an embodiment, the display device may further include a protective cover on at least one of the polarizing layer or the panel protecting member.

In an embodiment, the display device may further include a shock absorbing layer corresponding to at least a portion of a side of the polarizing layer.

In an embodiment, the shock absorbing layer may be configured to shield the at least the portion of the side of the polarizing layer and an upper surface of the polarizing layer at an edge portion of the polarizing layer.

In an embodiment, an end of the polarizing layer may protrude outward from an end of the display panel by 50 µm or more.

According to one or more embodiments of the present disclosure, an electronic device includes: a display device according to one or more embodiments of the present disclosure; and memory connected to the display device, and configured to store data.

In an embodiment, at least a portion of a planar shape of the display panel may be rounded.

In an embodiment, an end of the polarizing layer may protrude outward from an end of the display panel by 50 µm or more.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of the present disclosure will be more clearly understood from the following detailed description of the illustrative, nonlimiting embodiments with reference to the accompanying drawings, in which:
FIG. 1 is a block diagram of an electronic device according to an embodiment;
FIGS. 2 to 4 are schematic diagrams of some electronic devices according to some embodiments;
FIG. 5 is a schematic perspective view of an electronic device according to an embodiment;
FIG. 6 is an exploded perspective view schematically showing the electronic device illustrated in FIG. 5;
FIG. 7A is a plan view schematically showing a portion of a display device illustrated in FIG. 6;
FIG. 7B is a side view schematically showing a portion of the display device illustrated in FIG. 7A;
FIG. 8 is a plan view schematically showing a portion of a display device illustrated in FIG. 6;
FIG. 9 is a circuit diagram schematically showing a subpixel circuit of one subpixel disposed in a display area of FIG. 8;
FIGS. 10A and 10B are cross-sectional views schematically showing a portion of the electronic device illustrated in FIG. 5;
FIG. 10C is a cross-sectional view schematically illustrating a portion of a display device according to an embodiment;
FIG. 10D is a cross-sectional view schematically illustrating a portion of a display device according to an embodiment;
FIG. 11A is a plan view showing an order of manufacturing an electronic device;
FIGS. 11B and 11C are cross-sectional views showing an order of manufacturing an electronic device; and
FIG. 12 is a cross-sectional view of a display panel taken along the line A-A' of FIG. 8.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis direction, the y-axis direction, and the z-axis direction are not limited to directions corresponding to three axes of the rectangular coordinate system, and may be interpreted in a broader sense. For example, the x-axis direction, the y-axis direction, and the z-axis direction may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected to the other layer, area, or element with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the spirit and scope of the exemplary embodiments of the present invention.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

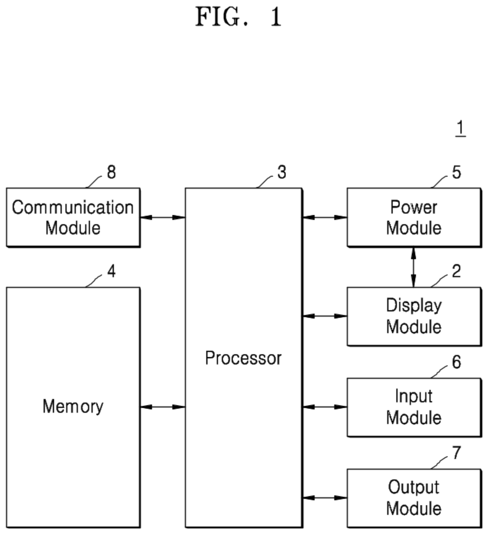

FIG. 1 is a block diagram of an electronic device according to an embodiment.

Referring to FIG. 1, an electronic device 1 according to an embodiment may include a display module (e.g., a display or a touch-display) 2 including a display panel, a processor 3, a memory 4, and a power module (e.g., a power circuit or a power supply circuit) 5.

The processor 3 may include at least one of a central processing unit (CPU), an application processor (AP), a graphics processing unit (GPU), a communication processor (CP), an image signal processor (ISP), and/or a controller. In an embodiment, the processor 3 may be functionally or structurally divided into two or more components. For example, the processor 3 may include a main processor in the form of a first driving chip including a CPU, and an auxiliary processor in the form of a second driving chip including a controller to receive an image signal from the main processor and to process the image signal so that the image signal matches interface specifications of the display module 2.

The memory 4 may include at least one of non-volatile memory and/or volatile memory. Data information for an operation of the processor 3 or the display module 2 may be stored in the memory 4. When the processor 3 executes an application stored in the memory 4, image data signals and/or input control signals may be transmitted to the display module 2, and the display module 2 may process the received signals to output image information through a display screen.

The power module 5 may include a power supply module, such as a power adapter or a battery device, and a power conversion module to convert power supplied by the power supply module and to generate power for the operation of the electronic device 1. Power conversion by the power conversion module may include, but is not limited to, DC-DC conversion, AC-DC conversion, and/or DC-AC conversion.

The electronic device 1 may further include an input module (e.g., an input device or circuit) 6, a non-image output module (e.g., a non-image output device or circuit) 7, and/or a communication module (e.g., a communication device or circuit) 8.

The input module 6 may provide input information to the processor 3 and/or the display module 2. The input module 6 may include various suitable sensor modules, as well as physical buttons, keyboards, and microphones. Examples of the sensor modules may include a touch sensor, a pressure sensor, a distance sensor, a position sensor, a digitizer, a motion recognition sensor, a camera sensor, a light-receiving sensor, a photoelectric conversion sensor, and/or a temperature sensor, as well as a bio-sensor, such as a blood pressure sensor, a blood sugar sensor, an electrocardiogram sensor, and/or a heart rate sensor.

The non-image output module 7 may receive information other than images from the processor 3, and may provide the information to the user. Examples of the non-image output module 7 may include a sound module, a haptic module, a light-emitting module, and the like, and/or may include other electronic device-specific functional modules (e.g., a cooling module of a refrigerator and/or the like).

The communication module 8 may transmit and receive information between the electronic device 1 and an external device, and may include a receiver and a transmitter. The communication module 8 may include various suitable wireless communication modules, such as a mobile communication module, a Wi-Fi module, a Bluetooth module, or various suitable wired communication modules.

At least one of the components of the electronic device 1 described above may be included in the display device according to some embodiments described in more detail below. Additionally, some of the individual modules functionally included in a module may be included in the display device, and others may be provided separately from the display device. For example, the display device may include the display module 2, and the processor 3, the memory 4, and the power module 5 may be provided as devices within the electronic device 1 excluding the display device. In some embodiments, the power module 5 may be provided in the display device, and may supply power to the processor 3 and the memory 4 provided in the electronic device 1, other than the display device, but the present disclosure is not limited thereto.

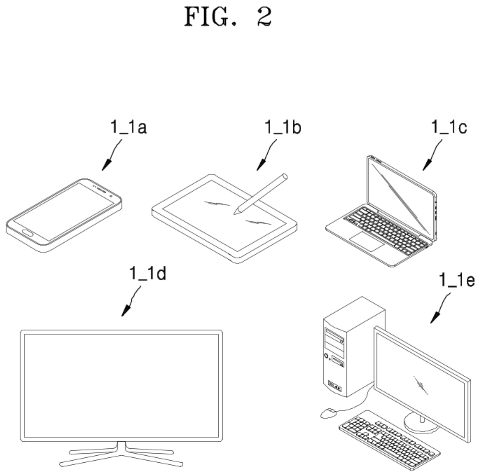

FIGS. 2 to 4 are schematic diagrams of some electronic devices according to some embodiments. FIGS. 2 to 4 illustrate examples of various electronic devices to which display devices according to some embodiments may be applied.

FIG. 2 illustrates a smartphone 1_1a, a tablet PC 1_1b, a laptop 1_1c, a TV 1_1d, and a desk monitor 1_1e as some examples of the electronic device.

The smartphone 1_1a may include an input module, such as a touch sensor, and a communication module, in addition to the display module. The smartphone 1_1a may process information received through the communication module or other input modules, and may display the information through the display module of the display device.

Similarly to the smartphone 1_1a, the tablet PC 1_1b, the laptop 1_1c, the TV 1_1d, and the desk monitor 1_1e may each include a display module and an input module, and may further include a communication module in some cases.

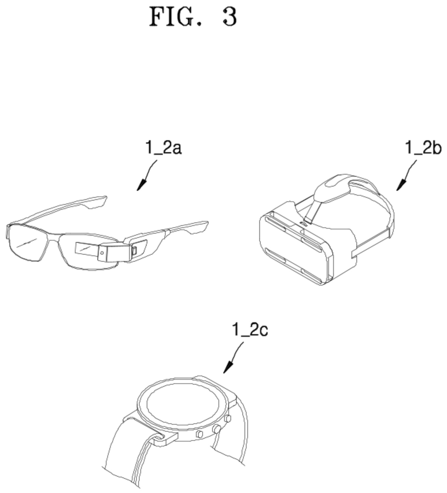

FIG. 3 illustrates an example in which the electronic device including the display module is applied to a wearable electronic device. The wearable electronic device may be smart glasses 1_2a, a head mounted display 1_2b, a smartwatch 1_2c, and the like.

The smart glasses 1_2a and the head mounted display 1_2b may include the display module to emit a display image, and a reflector to reflect and provide the emitted display image to the user's eyes, thereby providing a virtual reality screen or an augmented reality screen to the user.

The smartwatch 1_2c includes a bio-sensor as an input device, and may provide biometric information recognized by the bio-sensor to the user through the display module.

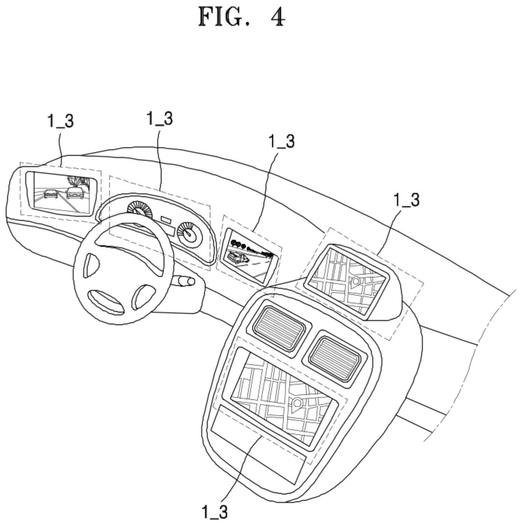

FIG. 4 illustrates an example in which the electronic device including the display module is applied to a vehicle. For example, the electronic device 1_3 may be applied to a dashboard, a center fascia, and the like of a vehicle, or to a center information display (CID) placed on a dashboard of a vehicle or a room mirror display that replaces a side mirror.

In other embodiments, the electronic devices to which display devices according to some embodiments may be applied may include not only devices that mainly display screens, such as billboards, electric sign boards, and game consoles, but may also include various suitable home appliances that display information through display modules, such as refrigerators, washing machines, dryers, air conditioners, and robot cleaners. In addition, when the display module has a function of transmitting light, the display module may be applied to electronic devices such as smart windows or transparent display devices that display a background and a display image together. The kinds of electronic devices according to some embodiments are not limited to those described above, and application of various other suitable electronic devices that are not explicitly described may also be possible.

For convenience of illustration, a case in which the electronic device 1 is a smartphone may be mainly described in more detail as a representative example.

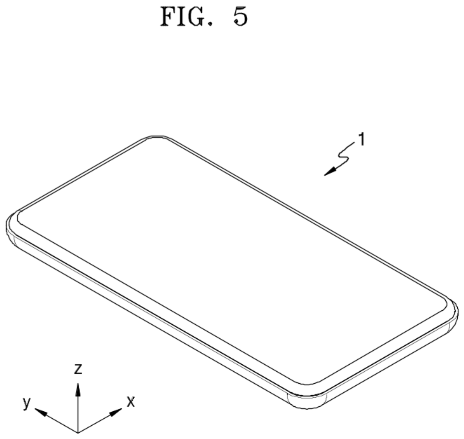

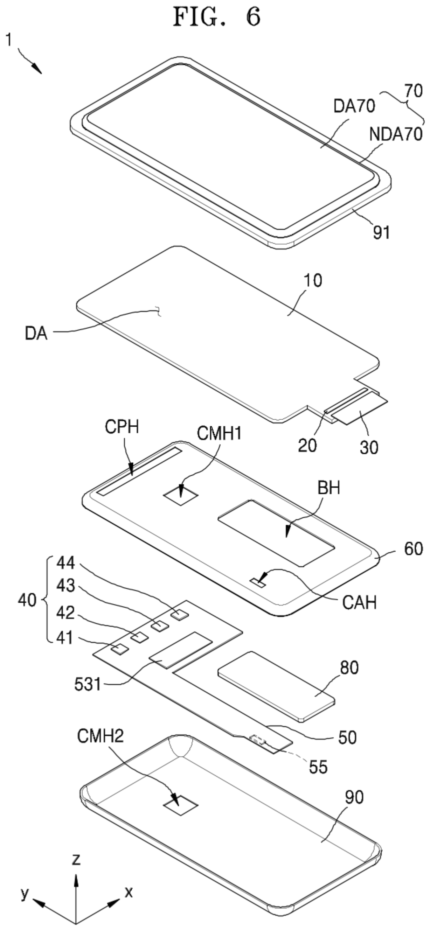

FIG. 5 is a schematic perspective view of an electronic device according to an embodiment. FIG. 6 is an exploded perspective view schematically showing the electronic device illustrated in FIG. 5.

Referring to FIGS. 5 and 6, the electronic device 1 may include a display device including a cover window 70, a display panel 10, a data driver 20, and a display circuit board 30. The electronic device 1 may further include a component 40, a bracket 60, a main circuit board 50, a battery 80, a lower cover 90, and/or an upper cover 91.

As used herein, in a plan view, "left," "right," "up," and "down" indicate directions when vertically facing the display panel 10. For example, "left" refers to the - x direction (i.e. the direction opposite to the x-axis direction), "right" refers to the +x direction (i.e. the x-axis direction), "up" refers to the +y direction (i.e. the y-axis direction), and "down" refers to the -y direction (i.e. the direction opposite to the y-axis direction).

The electronic device 1 may have a rectangular or a substantially rectangular shape in a plan view. For example, the electronic device 1 may have a rectangular or a substantially rectangular shape having a short side extending in the x-axis direction, and a long side extending in the y-axis direction in an xy-plane, as illustrated in FIG. 5. In this case, a corner in which the short side extending in the x-axis direction and the long side extending in the y-axis direction meet each other may form a right angle, or may have a rounded shape having a suitable curvature (e.g., a certain or predetermined curvature). In a flat surface, the electronic device 1 may have a polygonal shape other than a rectangular shape, or may have an elliptical shape, an irregular shape, or the like.

The cover window 70, which is a cover member, may be disposed on the display panel 10 to cover an upper surface of the display panel 10. The cover window 70 may protect the upper surface of the display panel 10.

The cover window 70 may include a transparent cover portion DA70 corresponding to the display panel 10, and a light-shielding cover portion NDA70 surrounding (e.g., around a periphery of) the transparent cover portion DA70. The light-shielding cover portion NDA70 may include an opaque material (e.g., a colored opaque material) that blocks light. The light-shielding cover portion NDA70 may include a pattern that may be displayed to the user when an image is not displayed.

The display panel 10 may be disposed on a lower portion of (e.g., under) the cover window 70. The display panel 10 may overlap with the transparent cover portion DA70 of the cover window 70. The display panel 10 includes a display area DA. The display area DA may display an image, and may include an area (hereinafter, a component area) that may transmit light emitted from the component 40 disposed below the display panel 10. The component 40 may include a sensor or a camera that utilizes visible light, infrared, sound, and/or the like.

The display panel 10 may be a light-emitting display panel including light-emitting diodes. The light-emitting diode may be an organic light-emitting diode including an emission layer, or an inorganic light-emitting diode including an inorganic material. The inorganic light-emitting diode may include a PN junction diode including inorganic semiconductor-based materials. When a voltage is applied to a PN junction diode in a forward direction, holes and electrons are injected, and energy generated by the recombination of the holes and electrons is converted into light energy to emit light of a desired color (e.g., a certain or predetermined color). The inorganic light-emitting diode may have a width from several micrometers to hundreds of micrometers. The inorganic light-emitting diodes may be referred to as micro LEDs.

The display panel 10 may be a rigid display panel that is rigid and does not bend easily, or a flexible display panel that is flexible and may be easily bent, folded, or rolled. For example, the display panel 10 may be a foldable display panel that may be folded and unfolded, a curved display panel in which a display surface is curved, a bent display panel in which an area other than the display surface is curved, a rollable display panel that may be rolled or unfolded, or a stretchable display panel that may be stretched.

The display panel 10 may be implemented as a transparent display panel that allows objects or backgrounds disposed on a lower surface of the display panel 10 to be viewed from the upper surface of the display panel 10. As another example, the display panel 10 may be a reflective display panel that reflects an object or background of the upper surface of the display panel 10.

The data driver 20 may be mounted on the display panel 10 in the form of an integrated circuit (IC). However, the present disclosure is not limited thereto, and for example, the data driver 20 may be mounted on the display circuit board 30.

The display circuit board 30 may be attached to one side of the display panel 10. The display circuit board 30 may be a flexible printed circuit board (FPCB) that is bendable, a rigid printed circuit board (PCB) that is hard and does not bend easily, or a composite printed circuit board including both the rigid PCB and the FPCB. A touch sensor driver may be mounted on the display circuit board 30. The touch sensor driver may be formed as an integrated circuit. The touch sensor driver may be electrically connected to touch electrodes of a touch screen layer of the display panel 10 through the display circuit board 30.

The touch screen layer of the display panel 10 may detect a user's touch input using at least one of several suitable touch methods, such as a resistive film method or a capacitive method. In the capacitive method in which the touch screen layer of the display panel 10 detects the user's touch input, the touch sensor driver applies driving signals to driving electrodes among the touch electrodes, and detects voltages charged in mutual capacitances between the driving electrodes and sensing electrodes through the sensing electrodes among the touch electrodes, thereby determining whether or not a user touch has occurred.

A user's touch may include a contact touch and a proximity touch. A contact touch refers to a user's finger or an object, such as a pen, being directly in contact with the cover window 70 disposed on the touch screen layer. A proximity touch refers to a user's finger or an object, such as a pen, being spaced apart from the cover window 70 in a close distance, such as hovering. The touch sensor driver may transmit sensor data to the main processor according to detected voltages, and the main processor may calculate touch coordinates at which the touch input occurred by analyzing the sensor data.

A controller for supplying driving voltages to drive subpixels, gate drivers and/or data drivers 20 of the display panel 10 may be disposed on the display circuit board 30.

The bracket 60 that supports the display panel 10 may be disposed on the lower portion of (e.g., below) the display panel 10. The bracket 60 may include a plastic, a metal, or both a plastic and a metal. The bracket 60 may include a first camera hole CMH1 into which a camera device 531 is inserted, a battery hole BH into which the battery 80 is disposed, a cable hole CAH through which a cable connected to the display circuit board 30 passes, and a component hole CPH corresponding to the components 40. The component hole CPH may overlap with the components 40 of the main circuit board 50 when viewed from a third direction (e.g., the z-axis direction). For reference, the display area DA of the display panel 10 may overlap with the components 40 of the main circuit board 50 when viewed from the third direction (e.g., the z-axis direction). The bracket 60 may not have the component hole CPH if the component hole CPH is unnecessary or undesired.

The component 40 included in the electronic device 1 may include a first component 41, a second component 42, a third component 43, and a fourth component 44 overlapping with the display panel 10. Each of the first component 41, the second component 42, the third component 43, and the fourth component 44 may include at least one of a proximity sensor, an illumination sensor, an iris sensor, a facial recognition sensor, and/or a camera (e.g., an image sensor). The proximity sensor using infrared rays may detect an object positioned close to the upper surface of the electronic device 1, and an illumination sensor may detect the brightness of light incident on an upper surface of the electronic device 1. Additionally, the iris sensor may capture an iris of a person positioned on the upper surface of the electronic device 1, and the camera may obtain image data of an object positioned on the upper surface of the electronic device 1. The component 40 is not limited to the proximity sensor, the illumination sensor, the iris sensor, the facial recognition sensor, and/or the camera, and may include other suitable sensors.

The main circuit board 50 and the battery 80 may be disposed on the lower portion of (e.g., under) the bracket 60. The main circuit board 50 may be a rigid PCB or an FPCB.

The main circuit board 50 may include the main processor, the camera device 531, a main connector 55, and the components 40. The main processor may be formed as an integrated circuit. As needed or desired, the electronic device 1 may include the camera device 531 disposed on the upper surface of the main circuit board 50, as well as the camera device 531 disposed on a lower surface of the main circuit board 50. Each of the main processor and the main connector 55 may be disposed on either the upper surface or the lower surface of the main circuit board 50. The main circuit board 50 may be electrically connected to the display circuit board 30 through the main connector 55 and/or the like.

The main processor may control all functions of the electronic device 1. For example, the main processor may output digital video data to the data driver 20 via the display circuit board 30, such that the display panel 10 displays an image. The main processor may receive the sensor data from the touch sensor driver. The main processor may determine whether or not a user's touch has occurred based on the sensor data, and may execute an action corresponding to the user's direct touch or proximity touch. The main processor may be an AP, a CPU, or a system chip composed of an integrated circuit.

The camera device 531 processes image frames, such as still images or moving images, obtained by an image sensor in a camera mode, and may output the processed image frames to the main processor. The camera device 531 may include at least one of a camera sensor (e.g., a charged coupled device (CCD), a complementary metal oxide semiconductor (CMOS)), a photo sensor (e.g., an image sensor), and/or a laser sensor.

A cable passing through the cable hole CAH of the bracket 60 may be connected to the main connector 55, and the main circuit board 50 may be electrically connected to the display circuit board 30 through the cable.

The electronic device 1 may include, in addition to the main processor, a wireless communication unit (e.g., a wireless communication circuit or device), an input unit (e.g., an input circuit or device), a sensor unit (e.g., a sensor circuit or device), an output unit (e.g., an output circuit or device), an interface unit (e.g., an interface circuit or device), a memory, and/or a power supplier.

The wireless communication unit may include at least one of a broadcast receiving module (e.g., a broadcast receiver), a mobile communication module (e.g., a mobile communication circuit or device), a wireless Internet module (e.g., a wireless Internet circuit or device), a short-range communication module (e.g., a short-range communication circuit or device), and/or a position information module (e.g., a position information circuit or device).

The broadcast receiving module receives broadcast signals and/or broadcast-related information from an external broadcast management server through a broadcast channel. The broadcast channel may include a satellite channel or a terrestrial channel.

The mobile communication module may transmit and receive wireless signals with at least one of a base station, an external terminal, and/or a server on a mobile communication network constructed according to technical standards or communication methods for mobile communication (e.g., global system for mobile communication (GSM), code division multi access (CDMA), code division multi access 2000 (CDMA 2000), enhanced voice-data optimized or enhanced voice-data only (EV-DO), wideband (WCDMA), high speed downlink packet access (HSDPA), high speed uplink packet access (HSUPA), long term evolution (LTE), long term evolution-advanced (LTE-A), and/or the like). Wireless signals may include voice call signals, image call signals, or various suitable forms of data according to text/multimedia message transmission and reception.

The wireless Internet module refers to a module or device for wireless internet access. The wireless Internet module may transmit and receive wireless signals in a communication network according to wireless Internet technologies. The wireless Internet technology may be, for example, wireless local area network (WLAN), wireless-fidelity (Wi-Fi), Wi-Fi direct, and/or digital living network alliance (DLNA).

The short range communication module may be used for short range communication, and may support short range communication using at least one of Bluetooth^{™}, radio frequency identification (RFID), infrared data association (IrDA), ultra-wideband (UWB), ZigBee, near field communication (NFC), Wi-Fi, Wi-Fi direct, and/or wireless universal serial bus technologies. The short-range communication module may support wireless communication, via the WLAN, between the electronic device 1 and a wireless communication system, between the electronic device 1 and another electronic device, or between the electronic device 1 and a network where the electronic device (or an external server) is positioned. The short-range wireless network may be a wireless personal area network. The other electronic device may be a wearable device to exchange (or link) data with the electronic device 1.

The position information module may obtain a position of the electronic device 1, and may include a global positioning system (GPS) module or a Wi-Fi module.

The input unit may include an image input unit, such as the camera device 531 to input image signals, a sound input unit, such as a microphone to input a sound signal, and an input device to receive information from the user. The camera device 531 processes image frames, such as still images or moving images, obtained by the image sensor in an image call mode or a shooting mode. The processed image frame may be displayed on the display panel 10 or stored in the memory. The microphone processes external acoustic signals into electrical voice data. The processed voice data may be utilized in various suitable ways depending on the function being performed (or the application being executed) in the electronic device 1.

The main processor may control an operation of the electronic device 1 to correspond to information input through the input device. The input device may include a mechanical input means or a touch input means, such as a button, a dome switch, a jog wheel, a jog switch, and/or the like, located on a rear or side of the electronic device 1. The touch input means may include a touch screen layer of the display panel 10.

The sensor unit may include one or more sensors to sense at least one of information in the electronic device 1, peripheral environment information surrounding the electronic device 1, and/or user information, and may generate sensing signals corresponding thereto. Based on the sensing signals, the main processor may control the driving or operation of the electronic device 1, process data, or perform functions or operations related to an application installed on the electronic device 1. The sensor unit may be a proximity sensor, an illumination sensor, or a facial recognition sensor as described above with respect to the components 40. The sensor unit may include an acceleration sensor, a magnetic sensor, a gravity (G)-sensor, a gyroscope sensor, a motion sensor, an RGB sensor, an infrared sensor (IR sensor), a finger scan sensor, an ultrasonic sensor, an optical sensor, and/or a battery gauge. In addition, the sensor unit may include an environmental sensor or a chemical sensor. The environmental sensor may be, for example, a barometer, a hygrometer, a thermometer, a radiation detection sensor, a heat detection sensor, and/or a gas detection sensor. The chemical sensor may be, for example, an electronic nose, a healthcare sensor, and/or a biometric sensor.

The output unit may generate visible, hearing, or haptic outputs, and may include at least one of the display panel 10, a sound output unit, a haptic module, and/or an optical output unit.

The display panel 10 may display (e.g., output) information processed in the electronic device 1. For example, the display panel 10 may display execution screen information of an application running on the electronic device 1, display a user interface (UI) according to the execution screen information, or display graphical user interface (GUI) information. The display panel 10 may include a display layer that displays an image, and a touch screen layer that detects the user's touch input. Accordingly, the display panel 10 may function as one of the input devices that provide an input interface between the electronic device 1 and the user, and at the same time, may function as one of the output units that provide an output interface between the electronic device 1 and the user.

The sound output unit may output sound data received from the wireless communication unit or stored in the memory in a call signal reception mode, a call mode, a recording mode, a voice recognition mode, and/or a broadcast reception mode. The sound output unit may also output sound signals related to a function performed in the electronic device 1 (e.g., a call signal reception sound, a message reception sound, and/or the like). The sound output unit may include a receiver and a speaker. At least one of the receiver and/or the speaker may be a sound generating device attached to the lower portion of the display panel 10 to vibrate the display panel 10 and output sound. The sound generating device may be a piezoelectric element or a piezoelectric actuator that contracts and expands in response to electric signals, or an exciter that generates magnetic force by using a voice coil to thereby vibrate the display panel 10.

The haptic module generates various haptic effects that the user may feel. The haptic module may provide vibrations to the user as a haptic effect. Haptic modules may not only convey tactile effects through a direct contact, but may also be implemented so that the user may feel haptic effects through their kinesthetic senses, such as their fingers or arms.

The optical output unit outputs signals to notify the occurrence of an event using light from a light source. Examples of events occurring in the electronic device 1 may include receiving a message, receiving a call signal, receiving a missed call, alarming, schedule reminding, receiving an email, and/or receiving information through an application. The signal output by the optical output unit is implemented by light emitted from the front or rear of the electronic device 1 in a single color or multiple colors. The signal output may be terminated when the electronic device 1 detects the user's acknowledgement of an event.

The interface unit serves as a passageway for various suitable kinds of external devices connected to the electronic device 1. The interface unit may include at least one of a wired/wireless headset port, an external charger port, a wired/wireless data port, a memory card port, a port configured to connect a device having an identification module, a sound input/output (I/O) port, a video I/O port, and/or an earphone port. When an external device is connected to the interface unit, the electronic device 1 may perform an appropriate controlling related to the connected external device.

The memory stores data that supports various functions of the electronic device 1. The memory may store a plurality of application programs running on the electronic device 1, and data and/or commands for the operation of the electronic device 1. At least some of the plurality of applications may be downloaded from an external server via a wireless communication. The memory may store applications for the operation of the main processor, and may also temporarily store input/output data, such as a phone book, a message, still images and/or moving images, and the like. Additionally, the memory may store haptic data for various patterns of vibration provided to the haptic module, and sound data for various sounds provided to the sound output unit.

The memory may include at least one kind of storage medium among a flash memory type, a hard disk type, a solid state disk (SSD) type, a silicon disk drive (SDD) type, a multimedia card micro type, a card type memory (e.g., an SD or XD memory, etc.), random access memory (RAM), static random access memory (SRAM), read-only memory (ROM), electrically erasable programmable read-only memory (EEPROM), programmable read-only memory (PROM), a magnetic memory, a magnetic disk, and/or an optical disk.

The power supplier, under the control of the main processor, receives external power and/or internal power, and supplies power to each component included in the electronic device 1. The power supplier may include the battery 80. Additionally, the power supplier may include a connection port, which may be an example of an interface unit to which an external charger that supplies power to charge the battery is electrically connected. As another example, the power supplier may allow the battery 80 to be charged wirelessly. The battery 80 may be disposed so as not to overlap with the main circuit board 50 in the third direction (e.g., the z-axis direction). The battery 80 may overlap with the battery hole BH of the bracket 60.

The lower cover 90 forms the exterior of the electronic device 1, and may have an opening that exposes a portion of the display panel 10. The lower cover 90 may have an open shape corresponding to the display panel 10, and may be coupled to the display panel 10. The lower cover 90 may be disposed on an opposite side of the cover window 70 with the display panel 10 therebetween. The lower cover 90 may be disposed below (e.g., under) the main circuit board 50 and the battery 80. The lower cover 90 may be fixed by being coupled to the bracket 60. The lower cover 90 may form the exterior of a lower surface of the electronic device 1. The lower cover 90 may include a plastic, a metal, or both a plastic and a metal.

A second camera hole CMH2 exposing a lower surface of the camera device 531 may be formed in the lower cover 90. The position of the camera device 531 and the positions of the first camera hole CMH1 and the second camera hole CMH2 corresponding to the camera device 531 are not limited to those illustrated in FIG. 6, and may be variously modified as needed or desired.

The cover window 70 may be inserted into the upper cover 91. The upper cover 91 may be formed in a similar shape as that of the lower cover 90, or in a frame shape so that the cover window 70 may be inserted thereinto. The upper cover 91 may be disposed on a side of an edge of the cover window 70, or on a lower surface of the edge of the cover window 70, and may be coupled to the bracket 60 and/or the lower cover 90.

In some embodiments, the electronic device 1 may not include the upper cover 91. In this case, if (e.g., when) the electronic device 1 does not include the upper cover 91, the cover window 70 may be coupled to the bracket 60 and/or the lower cover 90.

For convenience of illustration, the electronic device 1 including the upper cover 91, such that the upper cover 91 is coupled to the lower cover 90, may be described in more detail hereinafter, but the present disclosure is not limited thereto.

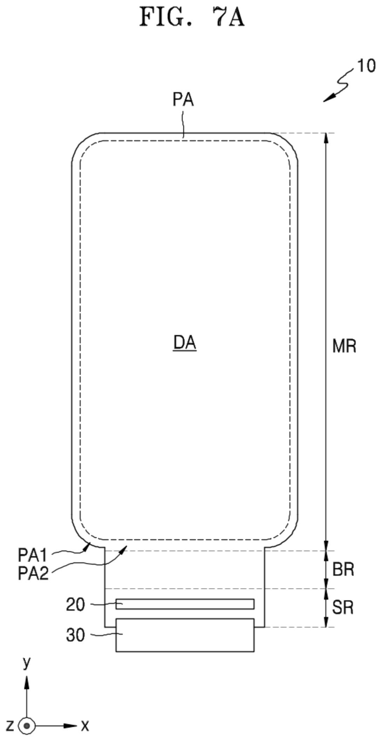

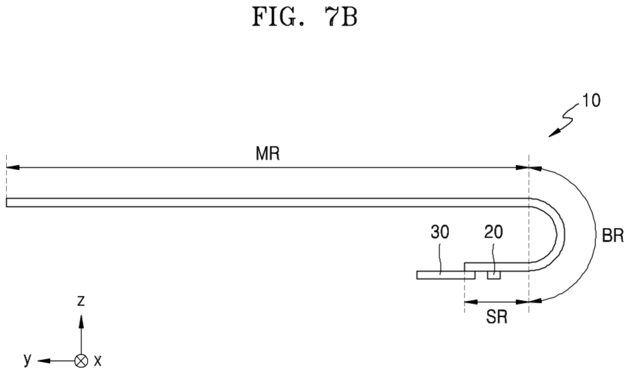

FIG. 7A is a plan view schematically showing a portion of the display device illustrated in FIG. 6. FIG. 7B is a side view schematically showing a portion of the display device illustrated in FIG. 7A. The electronic device 1 may include a portion of the display device, such as that illustrated in FIGS. 7A and 7B.

Referring to FIGS. 7A and 7B, the display device may include the display panel 10, the data driver 20, and the display circuit board 30.

The display panel 10 may include the display area DA, and a peripheral area PA outside the display area DA. The display area DA is a portion for displaying an image, and a plurality of pixels may be disposed in the display area DA. The display area DA may have various suitable shapes, such as a circular shape, an oval shape, a polygonal shape, a shape of a specific figure, and/or the like. In FIG. 7A, the display area DA has a rectangular or a substantially rectangular shape with rounded corners.

The peripheral area PA may be positioned outside the display area DA. The peripheral area PA may include a first peripheral area PA1 surrounding (e.g., around a periphery of) at least a portion of the display area DA, and a second peripheral area PA2 disposed on a lower end of the display area DA and extending in the first direction (e.g., the x-axis direction). A width of the second peripheral area PA2 in the first direction (e.g., the x-axis direction) may be less than a width of the display area DA in the first direction. As such, at least a portion of the second peripheral area PA2 may be easily bent.

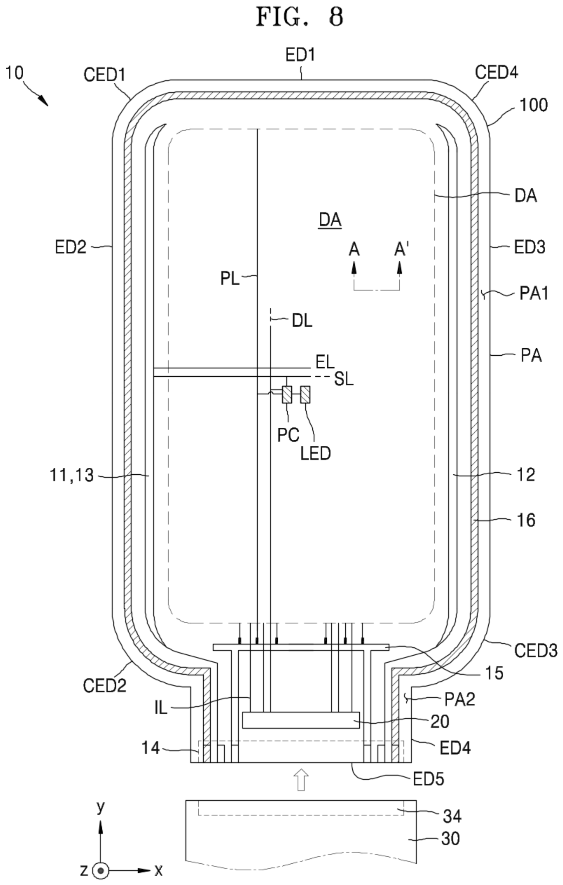

A planar shape of the display panel 10 of FIG. 7A may be the same or substantially the same as the shape of a substrate 100 (e.g., see FIG. 8) included in the display panel 10. When the display panel 10 includes the display area DA and the peripheral area PA outside the display area DA, it may be understood that the substrate 100 includes the display area DA and the peripheral area PA outside the display area DA. For convenience of illustration, the substrate 100 may be described in more detail hereinafter as including the display area DA and the peripheral area PA.

The display panel 10 may include a first area MR, a third area BR outside the first area MR, and a second area SR spaced apart from the first area MR with the third area BR therebetween. The first area MR may be disposed on one side of the third area BR, and the second area SR may be disposed on another side (e.g., an opposite side) of the third area BR. The display panel 10 may be bent in the third area BR as illustrated in FIG. 7B, and at least a portion of the second area SR may overlap with the first area MR in the third direction (e.g., the z-axis direction). FIG. 7B shows a bent display panel 10, but the present disclosure is not limited thereto. For example, the display panel 10 may be a foldable display panel, in which case, the display panel 10 may be bent within the display area DA about a bending axis crossing the display area DA. If necessary or desired, the display panel 10 may not be bent. The second area SR may include a non-display area.

The data driver 20 may be disposed in the second area SR of the display panel 10. The data driver 20 may disposed on the display panel 10 in the form of an integrated circuit (IC). For example, the data driver 20 may be a data driving integrated circuit that generates data signals.

The display circuit board 30 may be attached to an end of the second area SR of the display panel 10. The display circuit board 30 may be electrically connected to the data driver 20 or the like through a pad of the second area SR of the display panel 10.

FIG. 8 is a plan view schematically showing a portion of the display device illustrated in FIG. 6.

Referring to FIG. 8, the display panel 10 may include the substrate 100. Various components included in the display panel 10 may be disposed on the substrate 100.

The substrate 100 may include glass, ceramic, a metal, or a polymer resin. The substrate 100 may include a polymer resin, such as polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multilayered structure including two layers including the polymer resin, and an inorganic material layer disposed between the two layers. As another example, the substrate 100 may have a structure in which layers including the polymer resin and inorganic material layers are alternately stacked. The inorganic material layer may include a silicon oxide (SiOₓ), a silicon nitride (SiNₓ), and/or a silicon oxynitride (SiON).

The substrate 100 may include a plurality of edges that are connected to each other. For example, the substrate 100 may include a first edge ED1, a second edge ED2, a third edge ED3, a fourth edge ED4, and a fifth edge ED5 that are in the form of a straight line. The first edge ED1 and the fifth edge ED5 may be opposite to each other, and the second edge ED2 and the third edge ED3 may be opposite to each other. Additionally, a pair of fourth edges ED4 may be respectively connected to both sides (e.g., opposite sides) of the fifth edge ED5.

Additionally, the substrate 100 may include a first corner edge CED1, a second corner edge CED2, a third corner edge CED3, and a fourth corner edge CED4 that are rounded. The first corner edge CED1 may connect the first edge ED1 to the second edge ED2, the first edge ED1 and the second edge ED2 being adjacent to each other. The second corner edge CED2 may connect the second edge ED2 to the fourth edge ED4, the second edge ED2 and the fourth edge ED4 being adjacent to each other. The third corner edge CED3 may connect the third edge ED3 to the fourth edge ED4, the third edge ED3 and the fourth edge ED4 being adjacent to each other. The fourth corner edge CED4 may connect the third edge ED3 to the first edge ED1, the third edge ED3 and the first edge ED1 being adjacent to each other. In this case, a corner edge in the form of a curve may be disposed between all adjacent edges.

Subpixels are disposed in the display area DA, and the display area DA may provide an image using light emitted from the subpixels. Each subpixel may include a light-emitting diode LED, which is a display element, and the light-emitting diode LED may be electrically connected to a subpixel circuit PC. The subpixel circuit PC and the light-emitting diode LED may be disposed in the display area DA. For convenience of illustration, FIG. 8 shows that the subpixel circuit PC and the light-emitting diode LED are positioned side by side from each other, but the subpixel circuit PC and the light-emitting diode LED may actually overlap with each other at least partially. For example, the light emitting diode LED may be disposed on the subpixel circuit PC. Additionally, although only one light-emitting diode LED is illustrated in FIG. 8, a plurality of light-emitting diodes LED may be provided, and the plurality of light-emitting diodes LED may be spaced apart from each other across the entire display area DA. Additionally, some of the plurality of light-emitting diodes LED, some other LEDs, and others may emit different colors from each other.

A gate driving circuit, a pad 14, a first power supply wiring 15, and a second power supply wiring 16 may be disposed in the peripheral area PA. The gate driving circuit may include, for example, a first scan driving circuit 11, a second scan driving circuit 12, and/or a light emission control driving circuit 13.

The first scan driving circuit 11 may provide scan signals to the subpixel through a scan line SL. The second scan driving circuit 12 may be disposed opposite to the first scan driving circuit 11 with the display area DA therebetween. Some of the subpixel circuits PC disposed in the display area DA may be electrically connected to the first scan driving circuit 11, and others of the subpixel circuits PC may be connected to the second scan driving circuit 12. In some embodiments, the second scan driving circuit 12 may be omitted as needed or desired.

The light emission control driving circuit 13 may be disposed on one side of the display area DA, similarly to the first scan driving circuit 11. The light emission control driving circuit 13 may provide emission control signals to the subpixel through an emission control line EL. FIG. 8 shows that the light emission control driving circuit 13 is disposed only on one side of the display area DA, but the present disclosure is not limited thereto. For example, the display panel 10 may include light emission control driving circuits 13 respectively disposed on one side and another side (e.g., an opposite side) of the display area DA. As another example, the first scan driving circuit 11 may be disposed on one side of the display area DA, and the light emission control driving circuit 13 may be disposed on another side (e.g., an opposite side) of the display area DA.

The pad 14 may be disposed in the second peripheral area PA2 of the substrate 100. The pad 14 may not be covered by an insulating layer and may be exposed, thus being electrically connected to the display circuit board 30. The pad 34 of the display circuit board 30 may be electrically connected to the pad 14 of the display panel 10.

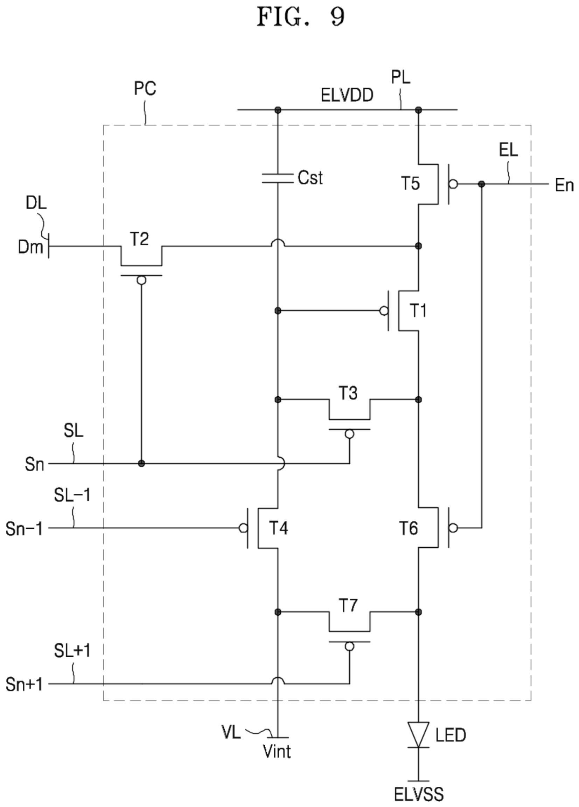

The display circuit board 30 may transmit signals or power from the controller to the display panel 10. The control signals generated in the controller may be transmitted to each gate driving circuit through the display circuit board 30. Additionally, the controller may provide a first power voltage ELVDD (see FIG. 9) and a second power voltage ELVSS (see FIG. 9) to the first power supply wiring 15 and the second power supply wiring 16, respectively. The first power voltage ELVDD (hereinafter referred to as a driving voltage) is provided to each subpixel circuit PC through a driving voltage line PL connected to the first power supply wiring 15, and the second power voltage ELVSS (hereinafter referred to as a common voltage) may be provided to a common electrode of the light-emitting diode LED connected to the second power supply wiring 16. The first power supply wiring 15 may extend in the first direction (e.g., the x-axis direction). The second power supply wiring 16 may have a loop shape with one open side, and thus, may partially surround (e.g., around a periphery of) the display area DA.

The data signals of the data driver 20 may be transmitted to the subpixel circuit PC through a data line DL electrically connected to an input line IL via the input line IL.

FIG. 9 is a circuit diagram schematically showing the subpixel circuit of one subpixel disposed in the display area of FIG. 8.

Referring to FIG. 9, the light emitting diode LED may be electrically connected to the subpixel circuit PC.

The subpixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a storage capacitor Cst.

The second thin-film transistor T2 may be a switching thin-film transistor, which is connected to the scan line SL and the data line DL, and may transmit a data voltage (e.g., a data signal Dm) input from the data line DL to the first thin-film transistor T1 based on a scan voltage (e.g., a scan signal Sn) input from the scan line SL. The storage capacitor Cst may be connected to the first thin-film transistor T1 and the driving voltage line PL, and may store a voltage corresponding to a difference between a voltage received from the second thin-film transistor T2 and the first power voltage ELVDD supplied to the driving voltage line PL.

The first thin-film transistor T1 may be a driving thin-film transistor, may be connected to the driving voltage line PL and the storage capacitor Cst, and may control a driving current flowing from the driving voltage line PL through the light-emitting diode LED according to a value of the voltage stored in the storage capacitor Cst. The light-emitting diode LED may emit light having a desired brightness (e.g., a certain or predetermined brightness) according to the driving current. A second electrode (e.g., a cathode) of the light-emitting diode LED may receive the second power voltage ELVSS.

The third thin-film transistor T3 may be a compensation thin-film transistor, and a gate electrode of the third thin-film transistor T3 may be connected to the scan line SL. A source electrode (or drain electrode) of the third thin-film transistor T3 may be connected to the drain electrode (or source electrode) of the first thin-film transistor T1, and may be connected to a first electrode of the light-emitting diode LED via the sixth thin-film transistor T6. The drain electrode (or source electrode) of the third thin-film transistor T3 may be connected to one electrode of the storage capacitor Cst, a source electrode (or drain electrode) of the fourth thin-film transistor T4, and a gate electrode of the first thin-film transistor T1. The third thin-film transistor T3 may be turned on according to the scan signal Sn received through the scan line SL, and may connect the gate electrode and drain electrode (or source electrode) of the first thin-film transistor T1 to each other, thereby diode-connecting the first thin-film transistor T1.

The gate electrode of the fourth thin film transistor T4 as an initialization thin-film transistor may be connected to a previous scan line SL-1. The drain electrode (or source electrode) of the fourth thin-film transistor T4 may be connected to an initialization voltage line VL. The source electrode (or drain electrode) of the fourth thin-film transistor T4 may be connected to one electrode of the storage capacitor Cst, a drain electrode (or source electrode) of the third thin-film transistor T3, and the gate electrode of the first thin-film transistor T1. The fourth thin-film transistor T4 may be turned on in response to a previous scan signal Sn-1 received through the previous scan line SL-1, and may transmit an initialization voltage Vint to the gate electrode of the first thin-film transistor T1, thereby performing an initialization operation of initializing a voltage of the gate electrode of the first thin-film transistor T1.

The fifth thin-film transistor T5 may be an operation control thin-film transistor, and the gate electrode of the fifth thin-film transistor T5 may be connected to the emission control line EL. The source electrode (or drain electrode) of the fifth thin-film transistor T5 may be connected to the driving voltage line PL. The drain electrode (or source electrode) of the fifth thin-film transistor T5 may be connected to the source electrode (or drain electrode) of the first thin-film transistor T1 and the drain electrode (or source electrode) of the second thin-film transistor T2.

The sixth thin-film transistor T6 may be an emission control thin-film transistor, and the gate electrode of the sixth thin-film transistor T6 may be connected to the emission control line EL. A source electrode (or a drain electrode) of the sixth thin-film transistor T6 may be connected to the drain electrode (or source electrode) of the first thin-film transistor T1 and the source electrode (or drain electrode) of the third thin-film transistor T3. The drain electrode (or source electrode) of the sixth thin-film transistor T6 may be electrically connected to the first electrode of the light-emitting diode LED. The fifth thin-film transistor T5 and the sixth thin-film transistor T6 may be concurrently (e.g., simultaneously or substantially simultaneously) turned on in response to an emission control signal En received through the emission control line EL, such that the first power voltage ELVDD is transmitted to the light-emitting diode LED and a driving current flows through the light-emitting diode LED.

The seventh thin-film transistor T7 may be an initialization thin-film transistor to initialize the first electrode of the light-emitting diode LED. A gate electrode of the seventh thin-film transistor T7 may be connected to a next scan line SL+1. A source electrode (or drain electrode) of the seventh thin-film transistor T7 may be connected to the first electrode of the light-emitting diode LED. The drain electrode (or source electrode) of the seventh thin-film transistor T7 may be connected to the initialization voltage line VL. The seventh thin-film transistor T7 may be turned on in response to the next scan signal Sn+1 received through the next scan line SL+1, such that the first electrode of the light-emitting diode LED is initialized.

In FIG. 9, the fourth thin-film transistor T4 and the seventh thin-film transistor T7 are respectively connected to the previous scan line SL-1 and the next scan line SL+1. However, in another embodiment, the fourth thin-film transistor T4 and the seventh thin-film transistor T7 may both be connected to the previous scan line SL-1 to be driven according to the previous scan signal Sn-1.

The other electrode of the storage capacitor Cst may be connected to the driving voltage line PL. One electrode of the storage capacitor Cst may be connected to the gate electrode of the first thin-film transistor T1, the drain electrode (or source electrode) of the third thin-film transistor T3, and the source electrode (or drain electrode) of the fourth thin-film transistor T4.

The second electrode (e.g., a cathode) of the light-emitting diode LED may receive the second power voltage ELVSS. The light-emitting diode LED emits light by receiving a driving current from the first thin-film transistor T1.

The light-emitting diode LED may be an organic light-emitting diode including an organic material as a light-emitting material. In another embodiment, the light-emitting diode may be an inorganic light-emitting diode including an inorganic material. The inorganic light-emitting diode may include a PN junction diode including inorganic semiconductor-based materials. When a voltage is applied to a PN junction diode in a forward direction, holes and electrons are injected, and energy generated by the recombination of the holes and electrons is converted into light energy to emit light of a desired color (e.g., a certain or predetermined color). The inorganic light-emitting diode may have a width of several to several hundred micrometers, or several to several hundred nanometers. In some embodiments, the light emitting diode LED may include a quantum dot light-emitting diode. As described above, the emission layer of the light-emitting diode LED may include an organic material, an inorganic material, quantum dots, an organic material and quantum dots, or an inorganic material and quantum dots. For convenience of illustration, the light-emitting diode LED including an organic light-emitting diode may be described in more detail hereinafter.

In FIG. 9 the subpixel circuit PC includes seven thin-film transistors and one capacitor. However, in another embodiment, the subpixel circuit PC may include two or more thin film transistors and two or more capacitors. In addition, a circuit design of the subpixel circuit PC is not limited to that illustrated in FIG. 9, and may be variously modified as needed or desired.

The first to seventh thin-film transistors T1, T2, T3, T4, T5, T6, and T7 may be various kinds of thin-film transistors. In an embodiment, all of the first to seventh thin-film transistors T1, T2, T3, T4, T5, T6, and T7, as illustrated in FIG. 9, may be a P-channel metal-oxide-semiconductor field-effect transistor (MOSFET) (PMOS transistors). In another embodiment, at least one of the first to seventh thin-film transistors T1, T2, T3, T4, T5, T6, and T7 may be a PMOS transistor, and the rest may be an N-channel MOSFET (NMOS transistor). In another embodiment, the first to seventh thin-film transistors T1, T2, T3, T4, T5, T6, and T7 may all be NMOS transistors. The positions of the sources and drains may be switched according to the kind of the thin-film transistor (a P-type or an N-type).

All of the first to seventh thin-film transistors T1, T2, T3, T4, T5, T6, and T7 illustrated in FIG. 9 may be thin-film transistors having low-temperature polysilicon semiconductor layers. However, the first to seventh thin-film transistors T1, T2, T3, T4, T5, T6, and T7 are not limited to the above, and at least one of the first to seventh thin-film transistors T1, T2, T3, T4, T5, T6, and T7 may be a thin-film transistor having a low-temperature polycrystalline silicon (LTPS) semiconductor layer, and the rest may be thin-film transistors having oxide semiconductor layers. As another example, all of the first to seventh thin-film transistors T1, T2, T3, T4, T5, T6, and T7 may be thin-film transistors having oxide semiconductor layers.

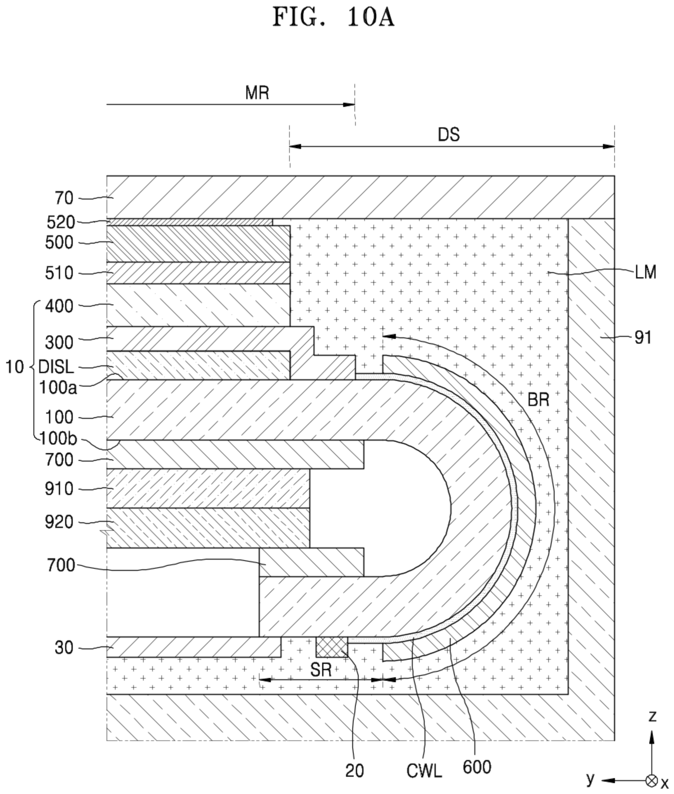

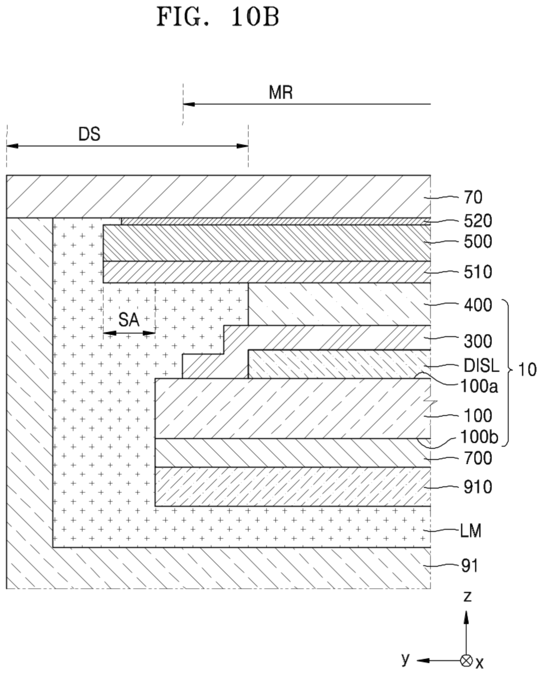

FIGS. 10A and 10B are cross-sectional views schematically showing a portion of the electronic device illustrated in FIG. 5. FIG. 10A is a cross-sectional view schematically showing a fifth edge portion of FIG. 8. FIG. 10B is a cross-sectional view schematically showing a first edge portion of FIG. 8.

Referring to FIGS. 10A and 10B, the display device may include a display panel 10 including the substrate 100, a display layer DISL, a thin-film encapsulation layer 300, and a sensor layer 400. The display device may further include a first adhesive layer 510, a polarizing film (or referred as a polarizing layer) 500, a second adhesive layer 520, the cover window 70, a protective film 700, a cover panel 910, and a cover spacer 920.

The substrate 100 may include the first and second areas MR and SR facing different directions from each other as described above, and the third area BR positioned therebetween.

The first area MR may include the display area DA. The first area MR may include a portion of a non-display area DS outside the display area DA in addition to the display area DA.

The display layer DISL, the thin-film encapsulation layer 300, the sensor layer 400, the first adhesive layer 510, the polarizing film 500, the second adhesive layer 520, and the cover window 70 may be stacked in the first area MR.

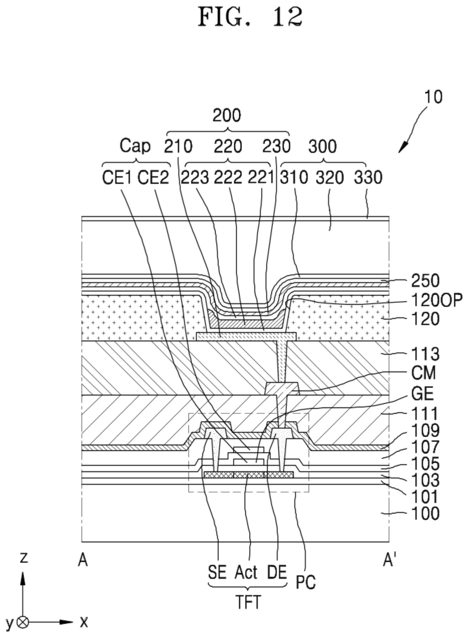

The display layer DISL may include a thin-film transistor TFT, a display element 200, and insulating layers therebetween, as described in more detail below with reference to FIG. 12. The thin-film encapsulation layer 300 may be formed in the display area DA and the non-display area DS in the first area MR to cover the display layer DISL.

In the first area MR, the sensor layer 400 may be provided on the thin-film encapsulation layer 300. The polarizing film 500 may be provided on the sensor layer 400.

The polarizing film 500 may reduce an external light reflection. For example, when external light passes through the polarizing film 500, is reflected from an upper surface of a counter electrode 230 (e.g., see FIG. 12), and then passes through the polarizing film 500 again, the phase of external light may be changed by passing through the polarizing film 500 twice. As a result, the phase of the reflected light becomes different from the phase of external light entering the polarizing film 500, thus causing an extinction interference. As a result, a visibility may be improved by reducing the external light reflection. The first adhesive layer 510 and the polarizing film 500 may overlap with a portion of the non-display area DS as well as the display area DA.

According to the position, an end of the polarizing film 500 may protrude more than the end of the display panel 10 (e.g., the end of the substrate 100) in a direction away from the display layer DISL. For example, the end of the polarizing film 500 may protrude more than the end of the display panel 10 (e.g., the end of the substrate 100) in a direction away from the display layer DISL at the first edge ED1, the second edge ED2, the third edge ED3, the first corner edge CED1, the second corner edge CED2, the third corner edge CED3, and/or the fourth corner edge CED4 illustrated in FIG. 8.

In this case, because the end of the polarizing film 500 has a section that protrudes more than the end of the display panel 10, damage to the display panel 10 may be reduced when an impact is applied from the outside. For example, if the end of the polarizing film 500 and the end of the display panel 10 are the same, or the end of the polarizing film 500 is closer to the display layer DISL than to the end of the display panel 10, when an impact is applied from the outside, the impact may also be transmitted to the end of the display panel 10. In this case, the protective layer 109 and the first organic insulating layer 111 illustrated in FIG. 12 may be separated from each other due to the external impact. In this case, if foreign matter or gas enters a space between the protective layer 109 and the first organic insulating layer 111, dark spots may occur on the display panel 10. Additionally, a wiring disposed around the third corner edge CED3 and/or the fourth corner edge CED4 may be short-circuited due to the impact, thereby causing the display panel 10 to not operate or malfunction.

However, according to some embodiments, as the end of the polarizing film 500 protrudes outward more than the end of the display panel 10, malfunction of or damage to the display panel may be reduced. The polarizing film 500 may include an area in which at least a portion thereof has a different light transmittance from that of another portion thereof. For example, the polarizing film 500 may include a semi-transparent area SA, which is a second area having a lower light transmittance than the light transmittance of another portion of the polarizing film 500 (e.g., a first area of the polarizing film 500 overlapping with the first area MR including the display area DA). In this case, the semi-transparent area SA may have a different color from that of other areas of the polarizing film 500. For example, the semi-transparent area SA may be yellow. Additionally, the semi-transparent area SA may be a portion of the polarizing film 500 disposed between the end of the display panel 10 and the end of the polarizing film 500. In this case, the semi-transparent area SA may be disposed over the entire portion of or only over a portion of the polarizing film 500 protruding from the end of the display panel 10. For convenience of illustration, a case in which the semi-transparent area SA is disposed over the entire portion of the polarizing film 500 protruding from the end of the display panel 10 may be mainly described in more detail below.

A width of the semi-transparent area SA may be 50 µm or more. In other words, the end of the polarizing film 500 may protrude outward from the end of the display panel 10 by at least 50 µm. In this case, if the end of the polarizing film 500 protrudes outward from the end of the display panel 10 by less than 50 µm, the polarizing film 500 may not be able to effectively absorb external impacts.

The first adhesive layer 510 may be disposed between the polarizing film 500 and the sensor layer 400. The first adhesive layer 510 may be an optically clear adhesive (OCA). However, the present disclosure is not limited thereto, and an optically clear resin (OCR) may be applied. In another embodiment, the first adhesive layer 510 may include a pressure sensitive adhesive (PSA). The PSA may include a polymer hardened product. The PSA may include an acrylic or rubber-based adhesive, or an adhesive in which fine particles, such as zirconia, are included in the adhesive. In some embodiments, the first adhesive layer 510 may be omitted as needed or desired, and the polarizing film 500 may be stacked on the sensor layer 400 rather than being a separate member.

The second adhesive layer 520 may include a light-transmitting adhesive layer that is the same or substantially the same as (or similar to) the first adhesive layer 510. In this case, a planar shape of the second adhesive layer 520 may be smaller than a planar shape of the polarizing film 500. In more detail, an edge of the second adhesive layer 520 may be disposed on an upper surface of the polarizing film 500, and the end of the polarizing film 500 may protrude more than the end of the second adhesive layer 520. In this case, the polarizing film 500 and the cover window 70 may be spaced apart from each other at the edge of the second adhesive layer 520, and a shock absorbing layer LM may be disposed between the polarizing film 500 and the cover window 70. In other words, the shock absorbing layer LM may surround (e.g., around peripheries of) at least a portion of a side surface of the polarizing film 500 and at least a portion of the upper surface of the polarizing film 500.

The end of the cover window 70 may protrude more than the end of the polarizing film 500. Accordingly, the cover window 70 may secure a space in which the cover window 70 may be coupled to a structure, such as the upper cover 91.

In this case, the light transmittance of the semi-transparent area SA may be different in the semi-transparent area SA. For example, light transmittance of the semi-transparent area SA may vary from one edge of the semi-transparent area SA to another edge (e.g., an opposite edge) of the semi-transparent area SA. In more detail, the light transmittance of the semi-transparent area SA may increase from one edge of or one of the other edges of the semi-transparent area SA toward the center of the semi-transparent area SA. In other words, the light transmittance of the semi-transparent area SA may sequentially decrease from the center of the semi-transparent area SA to an edge of the semi-transparent area SA.

The cover window 70 may be disposed on the polarizing film 500. The cover window 70 may provide a display surface to the user, and may protect the components underneath. The cover window 70 may correspond to the display area DA of the first area MR of the substrate 100, the non-display area DS, and the third area BR.

The cover window 70 may be formed to have a rigidity or a flexibility using glass, a plastic, and/or the like. Additionally, the cover window 70 may have a single-layer or multi-layered structure. When the cover window 70 has a multi-layered structure, the cover window 70 may be formed through a continuous process or an adhesive process using an adhesive layer.

The data driver 20 may be disposed in the second area SR. The data driver 20 may supply the data signal and the scan signal to a gate line and a data line by being connected to a pad portion of the substrate 100. The data driver 20 may be spaced apart from a bending protective layer 600. The data driver 20 may be, for example, a driver IC, and may be mounted on the pad portion of the substrate 100. In this case, the pad portion may be directly and electrically connected to the driver IC.

In another embodiment, the display circuit board 30 may be mounted on the pad portion of the substrate 100, and the driving integrated circuit may be mounted on the display circuit board 30. A chip on film (COF) or a flexible printed circuit (FPC) may be applied to the display circuit board 30, and the driver IC that provides a signal to light the plurality of display elements 200 of the display area DA may be mounted on the display circuit board 30. The data driver 20 and the display circuit board 30 may both be disposed in the second area SR, and various other modifications may be possible.

The third area BR of the substrate 100 may be disposed between the first area MR and the second area SR, and may be bent with a suitable inner radius (e.g., a certain or predetermined inner radius). A connection wire CWL may be disposed in the third area BR, and the bending protective layer 600 may be disposed on the connection wire CWL. The connection wire CWL may transmit signals provided from the data driver 20 and/or the display circuit board 30 to the display area DA of the first area MR. The bending protective layer 600, which may protect the connecting wire CWL, may be a stress neutralization layer. By positioning a stress neutral surface near (e.g., adjacent to) the connection wire CWL through the bending protective layer 600, a tensile stress applied to the connection wire CWL may be reduced. In some embodiments, the bending protective layer 600 may be omitted as needed or desired.

The substrate 100 may have a first surface 100a, and a second surface 100b positioned on an opposite side of the first surface 100a. The first surface 100a of the substrate 100 may refer to a front side of the substrate 100, and the second surface 100b may refer to a rear side of the substrate 100. The display layer DISL including the display elements 200 may be positioned on the first surface 100a of the substrate 100. The protective film 700, which is a panel protecting member, may be positioned on the second surface 100b of the substrate 100 opposite to the first surface 100a on which the display layer DISL is positioned, the second surface 100b being a side on which no image is displayed. The protective film 700 may be coated on or attached in the form of a film to the second surface 100b of the substrate 100. The protective film 700 may be attached to the second surface 100b of the substrate 100 to protect the display device. For example, the protective film 700 may absorb physical impacts from the outside, or may prevent or substantially prevent impurities or moisture from penetrating the display layer DISL. The protective film 700 may be patterned. The protective film 700 may be positioned in the first area MR and the second area SR of the substrate 100, and may not be positioned in the third area BR which may be bent. As the display panel 10 is bent in the third area BR, one portion and another portion of the protective film 700 may face each other.

The cover panel 910, which is a shielding member, may be disposed on a rear surface of the protective film 700. In an embodiment, an adhesive layer may be further disposed between the protective film 700 and the cover panel 910. The cover panel 910 may protect the display panel 10 from external impacts and the like.

The cover panel 910 may have a function of relieving external impacts, and may include a cushion layer including an elastically deformable material. For example, the cover panel 910 may include a single-layer or multi-layered cushion layer including at least one of thermoplastic elastomers, polystyrene, polyolefine, polyurethane thermoplastic elastomers, polyamides, synthetic rubbers, polydimethylsiloxane, polybutadiene, polyisobutylene, poly(styrene-butadienestyrene), polyurethanes, polychloroprene, polyethylene, silicone, and/or suitable combinations thereof. Additionally, the cover panel 910 may be formed of a suitable material among elastic materials that do not affect the displaying of an image by the display panel 10.

Additionally, the cover panel 910 may further include a high-strength plate (e.g., a metal plate), graphite, a copper plate, a heat dissipation plate, and/or the like to stably support the display panel 10 on the rear surface of the display panel 10.

For example, the cover panel 910 may include an embossed layer, an absorbing layer, and a support member sequentially disposed on the rear surface of the display panel 10. However, the structure of the cover panel 910 is not limited thereto, and the cover panel 910 may further include additional suitable elements having various suitable functions as needed or desired. Additionally, the relative positions (e.g., a stacking order) between the elements constituting the cover panel 910 may be variously modified as needed or desired. For example, in an embodiment, the embossed layer, the absorbing layer, and the supporting member may be sequentially disposed on the rear surface of the display panel 10, but in another embodiment, the supporting member may be disposed first on the rear surface of the display panel 10, and then the embossed layer and/or the absorbing layer may be disposed on the rear surface of the supporting member.

The embossed layer may include a plurality of embossed patterns that relieve and disperse external impacts and the like, and may be formed as a single layer or multiple layers. The absorbing layer may absorb external shocks by being filled with air, a dispersive material, or a sound-absorbing material, and may include a single layer or multiple layers. The embossed layer and the absorbing layer may be formed separately from each other, and may be coupled to each other by using an adhesive or glue. However, the present disclosure is not limited thereto, and the embossed layer and the absorbing layer may be formed in a single layer.

The support member may include a high-strength and/or high-ductility material to secure or improve a mechanical strength of the display device. For example, the support member may be a metal plate including at least one kind of a metal or an alloy. The support member may have a sufficient strength by having a thickness from about 10 µm to about several hundred µm. Accordingly, the mechanical strength of the display device may be obtained or improved.

The cover spacer 920 may control a degree of bending (e.g., a curvature) of the display panel 10 by uniformly maintaining a gap between the cover panel 910 and an area of the display panel 10 corresponding to the second area SR when the display panel 10 is bent. Additionally, the cover spacer 920 may support an area of the display panel 10 corresponding to the second area SR when the first area MR and the second area SR face each other during the bending of the display panel 10. In an embodiment, the cover spacer 920 may include, but is not limited to, the same material as that of the cover panel 910. For example, the cover spacer 920 may include an elastic material suitable for a condition of designing the display panel 10.

The shock absorbing layer LM may be disposed on the outside of the display panel 10, the sensor layer 400, and the polarizing film 500. In this case, the shock absorbing layer LM may be supplied in the form of a resin and may be hardened. Additionally, the shock absorbing layer LM may absorb some of the shock applied from the outside. The shock absorbing layer LM may be in direct contact with the end of the display panel 10, the end of the sensor layer 400, and the end of the polarizing film 500. In this case, the shock absorbing layer LM may be in direct contact with an upper surface and a side surface of the semi-transparent area SA.

The shock absorbing layer LM may be mounted in the upper cover 91, which is a housing. A portion of the upper cover 91 may be bent, such that the shock absorbing layer LM is disposed therein. In some embodiments, the shock absorbing layer LM may be fixed to one surface of the upper cover 91 via an adhesive layer.

If the electronic device does not include the upper cover 91, the shock absorbing layer LM may be disposed on the bracket 60 or the lower cover 90 described above with reference to FIG. 6. In this case, a method of disposing the shock absorbing layer LM may be the same as or similar to a case in which a mounting groove is provided in the bracket 60 or the lower cover 90, and the shock absorbing layer LM may be disposed in the mounting groove, as described above.

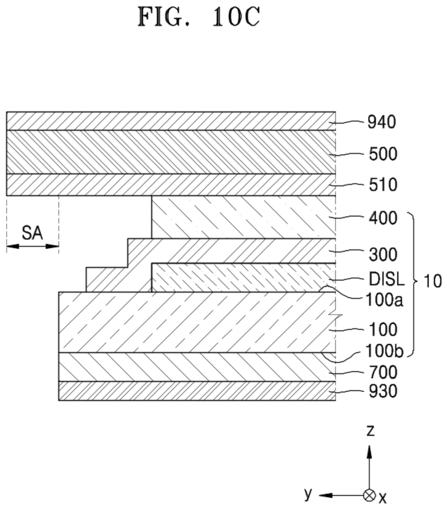

FIG. 10C is a cross-sectional view schematically illustrating a portion of the display device according to an embodiment. For example, FIG. 10C may illustrate another embodiment of the display device.

Referring to FIG. 10C, the display device may include the substrate 100, the display layer DISL, the thin-film encapsulation layer 300, the sensor layer 400, the first adhesive layer 510, the polarizing film 500, the protective film 700, a carrier film 930, and an upper protective film 940. In this case, the semi-transparent area SA of the polarizing film 500 may be the same as or similar to that described above.

The upper protective film 940, which is a protective cover, may be disposed on the polarizing film 500. The upper protective film 940 may protect the polarizing film 500. The upper protective film 940 may have the same size as that of the polarizing film 500. For example, the end of the upper protective film 940 may form a single plane with the end of the polarizing film 500.

The carrier film 930, which is a protective cover, may be disposed on a lower portion of the substrate 100. The carrier film 930 may have the same size as the substrate 100. In this case, the end of the carrier film 930 and the end of the substrate 100 may form the same plane.

In this case, the upper protective film 940 and/or the carrier film 930 may include polyimide, polyester, an epoxy resin, vinyl alcohol, and/or polycarbonate.

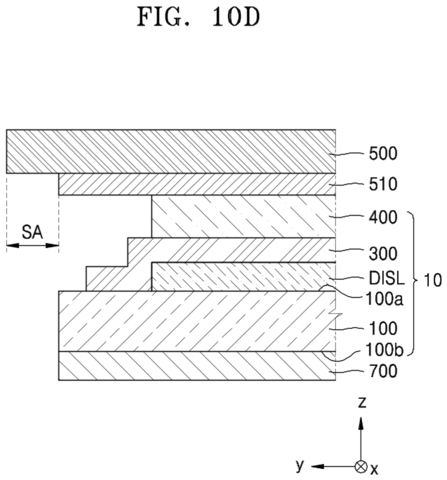

FIG. 10D is a cross-sectional view schematically illustrating a portion of the display device according to an embodiment. For example, FIG. 10D may illustrate another embodiment of the display device.

Referring to FIG. 10D, the display device may include the substrate 100, the display layer DISL, the thin-film encapsulation layer 300, the sensor layer 400, the first adhesive layer 510, the polarizing film 500, and the protective film 700. In this case, the semi-transparent area SA of the polarizing film 500 may be the same as or similar to that described above.

The first adhesive layer 510 may not be disposed in the semi-transparent area SA. In this case, a lower surface, a side surface, and an upper surface of the polarizing film 500 may be exposed to the outside in an edge area of the polarizing film 500.

In some embodiments, the display device may further include the cover window 70, the cover panel 910, the cover spacer 920, the shock absorbing layer LM, and the upper cover 91 as described above with reference to FIGS. 10A and 10B. In this case, the shock absorbing layer LM may be in direct contact with all of the upper, side, and lower surfaces of the semi-transparent area SA that protrudes outward from the end of the display panel 10.

In some embodiments, the display device may further include the carrier film 930 and the upper protective film 940 as described above with reference to FIG. 10C.

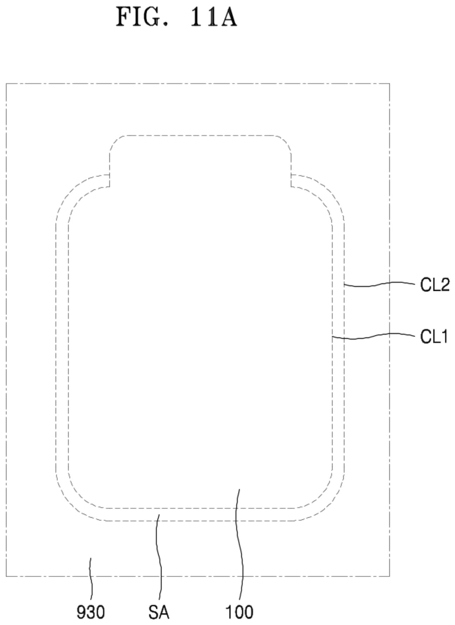

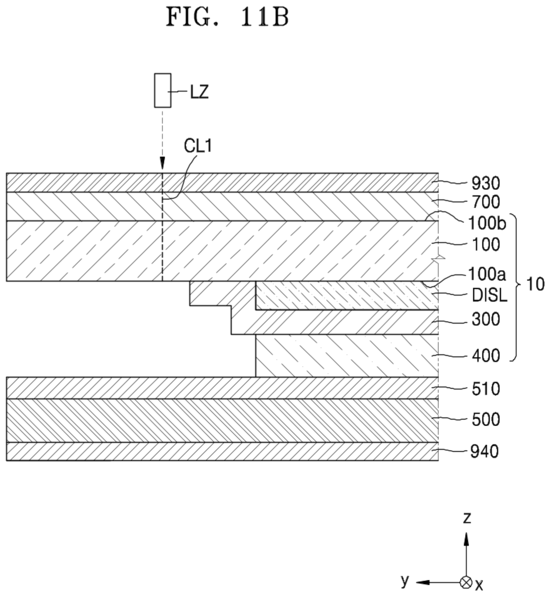

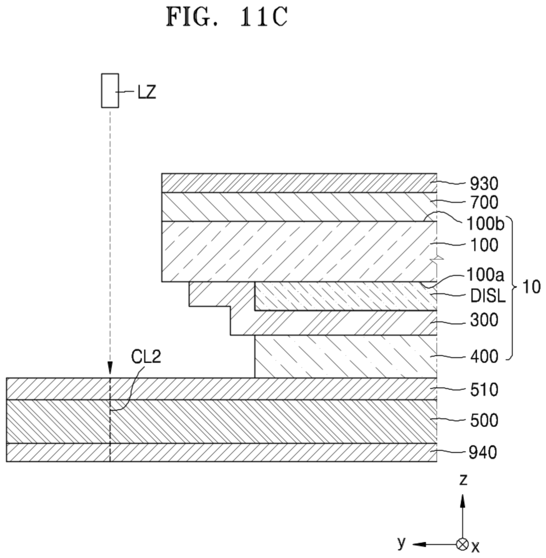

FIG. 11A is a plan view showing an order of manufacturing an electronic device. For example, FIG. 11A may illustrate one of the electronic devices illustrated in FIGS. 10A to 10D. FIGS. 11B and 11C are cross-sectional views showing an order of manufacturing an electronic device. For example, FIGS 11B and 11C may illustrate one of the electronic devices illustrated in FIGS. 10A to 10D.

Referring to FIGS. 11A to 11C, the carrier film 930 may be attached to the lower surface of the substrate 100 of the display panel 10, and the upper protective film 940 may be attached to the upper surface of the polarizing film 500. Subsequently, a first cutting line CL1 may be formed by disposing the upper protective film 940 on a stage, and then irradiating a laser on the carrier film 930 with a laser irradiating portion LZ. The first cutting line CL1 may be formed along the edge of the substrate 100. In this case, the first cutting line CL1 may penetrate the carrier film 930, the protective film 700, and the substrate 100, as illustrated in FIG. 11B. In another embodiment, the first cutting line CL1 may be formed up to the first adhesive layer 510. In this case, as illustrated in Fig. 10D, the first adhesive layer 510 may not be disposed in the semi-transparent area SA.

After forming the first cutting line CL1, a portion of each of the carrier film 930, the protective film 700, and the substrate 100 may be separated from another portion of each of the carrier film 930, the protective film 700, and the substrate 100 along the first cutting line CL1. Afterwards, the second cutting line CL2 may be formed in the polarizing film 500 through the laser irradiating portion LZ. In this case, the second cutting line CL2 may be disposed in the outer side of the first cutting line CL1. In some embodiments, when the first cutting line CL1 is formed in the first adhesive layer 510, the second cutting line CL2 may disposed only in the polarizing film 500. In another embodiment, the second cutting line CL2 may penetrate through the polarizing film 500 and the first adhesive layer 510.

After forming the second cutting line CL2, at least a portion of the polarizing film 500 may be removed along the second cutting line CL2. In this case, when the first cutting line CL1 is formed in the first adhesive layer 510, a portion of the first adhesive layer 510 disposed in the semi-transparent area SA between the first cutting line CL1 and the second cutting line CL2 may be removed together with the polarizing film 500 when the polarizing film 500 is removed along the second cutting line CL2. In another embodiment, the portion of the first adhesive layer 510 disposed in the semi-transparent area SA may be removed after the first cutting line CL1 is formed, and the second cutting line CL2 may be formed only in the polarizing film 500.

Accordingly, by forming the first cutting line CL1 and the second cutting line CL2, the polarizing film 500 may protrude outward from the end of the display panel 10, and may then be discharged. In another embodiment, after removing the carrier film 930 and the upper protective film 940, the cover window 70 may be disposed on the polarizing film 500, and a cover panel 910 and the cover spacer 920 may be disposed under the protective film 700.

In another embodiment, the second cutting line CL2 may be formed before the first cutting line CL1 is formed. In this case, the second cutting line CL2 may include the fourth edge ED4 (e.g., refer to FIG. 8) and the fifth edge ED5 (e.g., refer to FIG. 8) of the second area SR (e.g., refer to FIG. 7A). In this case, the display panel 10, the upper protective film 940, and the carrier film 930 may be separated along the second cutting line CL2. Subsequently, a portion of the carrier film 930, a portion of the protective film 700, and a portion of the substrate 100 may be removed by forming the first cutting line CL1 on the carrier film 930.

In this case, when forming the first cutting line CL1 and the second cutting line CL2, the laser irradiating portion LZ may irradiate the laser with a different intensity, a different number of irradiation, and/or a different irradiation time. Accordingly, damage to each layer of the display device due to the laser irradiation may be reduced.

FIG. 12 is a cross-sectional view of the display panel taken along the line A-A' of FIG. 8.

Referring to FIG. 12, the display panel 10 may include the substrate 100. The substrate 100 may include glass, a metal, or a polymer resin. In the case where the substrate 100 is flexible or bendable, the substrate 100 may include, for example, a polymer resin, such as polyethersulfone, polyacrylate, polyetherimide, polyethylene naphthalate, polyethylene terephthalate, polyphenylene sulfide, polyarylate, polyimide, polycarbonate, and/or cellulose acetate propionate. For example, the substrate 100 may have a multilayered structure including an uneven layer including two layers including the polymer resin, and an inorganic material layer disposed between the two layers. For example, the uneven layer may include an inorganic material, such as SiOₓ, SiNₓ, and/or a SiON.

A buffer layer 101 may be disposed on the substrate 100. The buffer layer 101 may block impurities or moisture penetrating through the substrate 100. For example, the buffer layer 101 may include an inorganic material, such as SiOₓ, SiNₓ, and/or SiON, and may be formed as a single layer or multiple layers.

On the substrate 100, thin-film transistors TFT, storage capacitors Cap, and organic light-emitting diodes may be disposed corresponding to the display area DA. The organic light-emitting diodes may be display elements 200 electrically connected to the thin-film transistors TFT and the storage capacitors Cap.

The thin-film transistor TFT may include a semiconductor layer Act, a gate electrode GE overlapping with a channel area of the semiconductor layer Act, and a source electrode SE and drain electrode DE respectively connected to a source area and a drain area of the semiconductor layer Act.

The semiconductor layer Act may include polysilicon. In some embodiments, the semiconductor layer Act may include amorphous silicon. In some embodiments, the semiconductor layer Act may include an oxide of at least one of indium (In), gallium (Ga), stannum (Sn), zirconium (Zr), vanadium (V), hafnium (Hf), cadmium (Cd), germanium (Ge), chromium (Cr), titanium (Ti), and/or zinc (Zn). The semiconductor layer Act may include the channel area, and the source area and drain area doped with impurities.

The gate electrode GE may include a low-resistance conductive material, such as molybdenum (Mo), aluminum (Al), copper (Cu), and/or titanium (Ti), and may have a single-layer or multi-layered structure.

The source electrode SE or the drain electrode DE may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer or multi-layered structure including one or more of the materials described above. For example, the source electrode SE or drain electrode DE may have a three-layered structure of Ti/Al/Ti. The source electrode SE and the drain electrode DE may be disposed at (e.g., on or in) the same layer as each other.

A gate insulating layer 103 may be disposed between the semiconductor layer Act and the gate electrode GE, such that an insulation between the semiconductor layer Act and the gate electrode GE is obtained. The gate insulating layer 103 may include an inorganic insulating material, such as SiOₓ, SiNₓ, SiON, aluminum oxide, titanium oxide, tantalum oxide, hafnium oxide, and/or zinc oxide. The gate insulating layer 103 may include a single layer or multi-layers including one or more of the materials described above.

The storage capacitor Cap may include a lower electrode CE1 and an upper electrode CE2 overlapping with each other, with a first interlayer insulating layer 105 therebetween. In an embodiment, the storage capacitor Cap may overlap with the thin-film transistor TFT, and the gate electrode GE of the thin-film transistor TFT may function as the lower electrode CE1 of the storage capacitor Cap. In another embodiment, the storage capacitor Cap may not overlap with the thin-film transistor TFT. The storage capacitor Cap may be covered by a second interlayer insulating layer 107. The upper electrode CE2 of the storage capacitor Cap may include a conductive material including Mo, Al, Cu, Ti, and/or the like, and may include a single layer or multiple layers including one or more of the materials described above.

The first interlayer insulating layer 105 and the second interlayer insulating layer 107 may be disposed on the gate insulating layer 103, and may include an inorganic insulating material, such as SiOₓ, SiNₓ, or SiON. The first interlayer insulating layer 105 and the second interlayer insulating layer 107 may include a single layer or multiple layers including one or more of the materials described above.

The protective layer 109 may be disposed on the second interlayer insulating layer 107. The protective layer 109 may cover the thin-film transistor TFT in the display area DA. The protective layer 109 may include, for example, SiNₓ. Hydrogen included in silicon nitride may improve characteristics of the thin-film transistors by removing defect sites in the semiconductor layer by combining with dangling bonds in the semiconductor layer of the thin-film transistor.

The first organic insulating layer 111 may be disposed on the protective layer 109. The first organic insulating layer 111 may include an organic insulating material, such as a general-purpose polymer, such as polymethylmethacrylate (PMMA) or polystyrene (PS), polymer derivatives having a phenol-based group, acrylic-based polymers, arylether-based polymers, amide-based polymers, fluorine-based polymers, p-xylene-based polymers, vinyl alcohol-based polymers, and/or a suitable blend thereof. In an embodiment, the first organic insulating layer 111 may include polyimide.

A bond between the first organic insulating layer 111 and the protective layer 109 may be less than a bond between other layers. In this case, the first organic insulating layer 111 and the protective layer 109 may be separated from each other by an external impact, or a portion of the first organic insulating layer 111 and a portion of the protective layer 109 may be separated from each other, thereby forming a space between the portion of the first organic insulating layer 111 and the portion of the protective layer 109. Because the first organic insulating layer 111 may be separated from the protective layer 109, damage to wires, metal patterns, and the like disposed on the first organic insulating layer 111, on the protective layer 109, and/or between the first organic insulating layer 111 and the protective layer 109 may cause the display panel 10 to not operate, or a space between the first organic insulating layer 111 and the protective layer 109 may cause dark spots to occur in the display area DA.

The second organic insulating layer 113 may be disposed on the first organic insulating layer 111. The second organic insulating layer 113 may include amide-based polymers, a general-purpose polymer, such as PMMA or PS, polymer derivatives having a phenol-based group, acrylic-based polymers, amide-based polymers, aryl ether-based polymers, fluorine-based polymers, p-xylene-based polymers, vinyl alcohol-based polymers, and/or a suitable blend thereof. In an embodiment, the second organic insulating layer 113 may include polyimide.

A subpixel electrode 210 may be disposed on the second organic insulating layer 113. The subpixel electrode 210 may include a light-transmitting conductive layer including a light-transmitting conductive oxide, such as indium tin oxide (ITO), indium oxide (In₂O₃), indium zinc oxide (IZO), or the like, and a reflective layer including a metal, such as Al, Ag, or the like. For example, the subpixel electrode 210 may have a three-layered structure including ITO/Ag/ITO. The subpixel electrode 210 may be connected to a contact metal CM through a contact hole formed in the second organic insulating layer 113, and the contact metal CM may be electrically connected to the thin-film transistor TFT by being in contact with one of the source electrode SE or the drain electrode DE through a contact hole formed in the protective layer 109 and the first organic insulating layer 111. In other words, the subpixel electrode 210 may be electrically connected to the thin-film transistor TFT through the contact metal CM.

A bank layer 120 may be disposed on the subpixel electrode 210, and the bank layer 120 has an opening 120OP corresponding to each subpixel, or in other words, an opening 120OP that exposes at least a central portion of the subpixel electrode 210, thereby defining an emission area of the subpixel. Additionally, arcs and the like may be prevented or substantially prevented from occurring between the edge of the subpixel electrode 210 and the counter electrode 230 by increasing a distance between the subpixel electrode 210 and the counter electrode 230. The bank layer 120 may include an organic material, such as polyimide or hexamethyldisiloxane (HMDSO).

An intermediate layer 220 may be disposed on the bank layer 120. The intermediate layer 220 may be disposed between the subpixel electrode 210 and the counter electrode 230.

The intermediate layer 220 may include an emission layer 222 corresponding to the subpixel electrode 210. The emission layer 222 may include an organic light-emitting material, such as a high molecular-weight or low molecular-weight organic material for emitting a desired color (e.g., a certain or predetermined color) of light. As another example, the emission layer 222 may include an inorganic light-emitting material or quantum dots.

A first functional layer 221 and a second functional layer 223 may respectively be disposed above and below the emission layer 222. The first functional layer 221 may include a single layer or multiple layers. For example, the first functional layer 221 may be a single-layer HTL (such as a hole transport layer HTL), and may include poly-(3,4-ethylene-dioxy thiophene) (PEDOT) or polyaniline (PANI). As another example, the first functional layer 221 may include a hole injection layer (HIL) and a hole transport layer (HTL). The second functional layer 223 may include a single layer or multiple layers. The second functional layer 223 may include an electron transport layer (ETL) and/or an electron injection layer (EIL).

While the emission layer 222 of the intermediate layer 220 is disposed for each subpixel, the first functional layer 221 and the second functional layer 223 may be formed in a single body to cover a plurality of subpixels. In other words, the first functional layer 221 and the second functional layer 223 may be a common layer. The first functional layer 221 and the second functional layer 223 may extend from the display area DA to the peripheral area PA.

The counter electrode 230 may be disposed on the intermediate layer 220, and may cover the entire surface of the display area DA. In other words, the counter electrode 230 may be integrally formed to cover a plurality of subpixels. The counter electrode 230 may extend from the display area DA to the peripheral area PA. The counter electrode 230 may include a conductive material having a low work function. For example, the counter electrode 230 may include a (semi-)transparent layer including Ag, Mg, Al, Pt, Pd, Au, Ni, Nd, Ir, Cr, Li, Ca, and/or a suitable alloy thereof. The counter electrode 230 may further include a layer including ITO, IZO, ZnO, and/or In₂O₃ on the (semi-)transparent layer including one or more of the above materials.

A laminated structure of the subpixel electrode 210, the intermediate layer 220, and the counter electrode 230 may form an organic light-emitting diode as the display element 200. Organic light-emitting diodes, which are light-emitting diodes, may emit red, green, or blue light. The opening 120OP of the bank layer 120 may define the size and/or the width of the emission area.

A capping layer 250 may be formed on the counter electrode 230. The capping layer 250 may include an organic insulator and/or an inorganic insulator, such as SiNₓ. In some embodiments, the capping layer 250 may be omitted as needed or desired. The capping layer 250 may cover the display area DA, and may extend from the display area DA to the peripheral area PA.

The thin-film encapsulation layer 300 may cover the display element 200, and may prevent or substantially prevent damage due to moisture or oxygen from the outside. The thin-film encapsulation layer 300 may cover the display area DA, and may extend from the display area DA to the peripheral area PA. The thin-film encapsulation layer 300 may include at least one inorganic encapsulation layer and at least one organic encapsulation layer. FIG. 12 illustrates a case in which the thin-film encapsulation layer 300 includes a first inorganic encapsulation layer 310, an organic encapsulation layer 320, and a second inorganic encapsulation layer 330.

The first inorganic encapsulation layer 310 may cover the counter electrode 230, and may include SiOₓ, SiNₓ, and/or SiON. Because the first inorganic encapsulation layer 310 is formed along a structure therebelow, the first inorganic encapsulation layer 310 may not have a planar upper surface. The organic encapsulation layer 320 covers the first inorganic encapsulation layer 310, and unlike the first inorganic encapsulation layer 310, the upper surface of the organic encapsulation layer 320 may be approximately planarized. In more detail, the surface of a portion of the organic encapsulation layer 320 corresponding to the display area DA may be approximately planar. The organic encapsulation layer 320 may include a polymer-based material. Examples of the polymer-based material may include an acrylic resin, an epoxy resin, polyimide, and polyethylene. Acrylic resins may include, for example, polymethyl methacrylate, polyacrylic acid, and the like. The organic encapsulation layer 320 may have a transparency. The second inorganic encapsulation layer 330 may cover the organic encapsulation layer 320, and may include SiOₓ, SiNₓ, and/or SiON.

The first and second inorganic encapsulation layers 310 and 330 may be formed by chemical vapor deposition (CVD), and the organic encapsulation layer 320 may be formed by a process of applying a liquid organic material on the substrate 100 and then hardening the liquid organic material.

The sensor layer 400 may be disposed on the thin-film encapsulation layer 300. The sensor layer 400 may include a first sensor insulating layer, a second sensor insulating layer, and a third sensor insulating layer. Additionally, the sensor layer 400 may include a first sensor electrode disposed between the first sensor insulating layer and the second sensor insulating layer, and a second sensor electrode disposed between the second sensor insulating layer and the third sensor insulating layer. The first sensor electrode and the second sensor electrode may be driving electrodes and sensing electrodes. The first sensor electrode may be electrically connected to the second sensor electrode through a contact hole defined in the second sensor insulating layer.

The first sensor insulating layer may include at least one inorganic insulating material selected from SiOₓ, SiNₓ, SiON, aluminum oxide, titanium oxide, tantalum oxide, hafnium oxide, and/or zinc oxide. The first sensor insulating layer may have a single-layer or multi-layered structure. In another embodiment, the first sensor insulating layer may include at least one of an acrylic resin, a methacrylic resin, a polyisoprene, a vinyl resin, an epoxy resin, a urethane resin, a cellulose resin, a siloxane resin, a polyimide resin, a polyamide resin, and/or a perylene resin. The first sensor insulating layer may be omitted as needed or desired.

The second sensor insulating layer may include at least one inorganic insulating material selected from SiOₓ, SiNₓ, SiON, aluminum oxide, titanium oxide, tantalum oxide, hafnium oxide, and/or zinc oxide. The second sensor insulating layer may have a single-layer or multi-layered structure. In another embodiment, the second sensor insulating layer may include at least one of an acrylic resin, a methacrylic resin, a polyisoprene, a vinyl resin, an epoxy resin, a urethane resin, a cellulose resin, a siloxane resin, a polyimide resin, a polyamide resin, and/or a perylene resin.

In the display device and the electronic device according to some embodiments, damage to the wirings inside the display device that may be caused by external impacts may be reduced.

In the display device and the electronic device according to some embodiments, the occurrence of dark spots inside the display device that may be caused by external impacts may be reduced.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure as defined by the appended claims. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims.

## Claims

1. A display device comprising:
a display panel (10) comprising a first surface configured to display an image, and a second surface opposite to the first surface;
a polarizing layer (500) on the first surface of the display panel (10), at least a portion of the polarizing layer (500) protruding outward from the display panel (10) more than at least a portion of an edge of the display panel (10); and
a shock absorbing layer (LM) corresponding to at least a portion of a side of the polarizing layer (500), and configured to shield the at least the portion of the side of the polarizing layer (500) and an upper surface of the polarizing layer (500) at an edge portion of the polarizing layer (500).

2. The display device of claim 1, further comprising a housing (91) in which the shock absorbing layer (LM) is accommodated.

3. A display device comprising:
a display panel (10) comprising a first surface configured to display an image, and a second surface opposite to the first surface; and
a polarizing layer (500) on the first surface, the polarizing layer (500) comprising:
a first area overlapping with a display area of the display panel (10); and
a second area extending from the first area,
wherein at least a portion of the second area protrudes outward from the display panel (10) more than at least a portion of an edge of the display panel (10), and
wherein a light transmittance of the second area is different from a light transmittance of the first area.

4. The display device of claim 3, wherein the light transmittance of the first area is greater than the light transmittance of the second area.

5. The display device of claim 3 or 4, further comprising a shock absorbing layer (LM) corresponding to at least a portion of a side of the polarizing layer (500).

6. The display device of claim 5, wherein the shock absorbing layer (LM) is configured to shield the at least the portion of the side of the polarizing layer (500) and an upper surface of the polarizing layer (500) at an edge portion of the polarizing layer (500).

7. The display device of any one of the preceding claims, further comprising a cover member (70) on the polarizing layer (500).

8. The display device of claim 7, wherein an end of the cover member (70) protrudes outward from the polarizing layer (500) more than an end of the polarizing layer (500).

9. The display device of any one of the preceding claims, further comprising a panel protecting member (700) on the second surface of the display panel (10).

10. The display device of claim 9, further comprising a shielding member (910) on a surface of the panel protecting member (700).

11. The display device of claim 9 or 10, further comprising a protective cover (940) on at least one of the polarizing layer (500) or the panel protecting member (700).

12. The display device of any one of the preceding claims, wherein at least a portion of a planar shape of the display panel (10) is rounded.

13. The display device of any one of the preceding claims, wherein an end of the polarizing layer (500) protrudes outward from an end of the display panel (10) by 50 µm or more.

14. An electronic device (1, 1_3) comprising:
a display device of any one of the preceding claims; and
memory (4) connected to the display device, and configured to store data.

15. The electronic device (1, 1_3) of claim 14, further comprising an input module (6), a non-image output module (7), and/or a communication module (8).
